# EUROPEAN PATENT SPECIFICATION

(11) **EP 2 117 125 B1**
(45) Date of publication and mention of the grant of the patent: **02.03.2011**
(21) Application number: 08155894.2
(22) Date of filing: 08.05.2008
(51) Int. Cl.: H04B 1/38, H03H 7/06

(54) **Mobile wireless communications device with reduced harmonics resulting from metal shield coupling**
Mobile drahtlose Kommunikationsvorrichtung mit verminderten Schwingungen infolge von Metallschirmkopplung
Dispositif mobile de communications sans fil à harmoniques réduites résultant du couplage d'un blindage métallique

(43) Date of publication of application: 11.11.2009
(73) Proprietor: RESEARCH IN MOTION LIMITED, Waterloo, Ontario N2L 3W8 (CA)
(72) Inventor: Zhu, Lizhong, Waterloo, Ontario, N2T 2T8 (CA); Mankaruse, George, Kitchener, Ontario, N2P 2Y2 (CA); Corrigan, Michael, Waterloo, Ontario, N2T1S5 (CA)
(74) Representative: Roberts, Gwilym Vaughan

(56) References cited:
- EP-A- 0 279 137
- US-A1- 2007 273 602

## Description

### Field of the Invention

The present invention relates to the field of communications devices, and more particularly, to mobile wireless communications devices and related methods.

### Background of the Invention

Cellular communication systems continue to grow in popularity and have become an integral part of both personal and business communications. Cellular telephones allow users to place and receive phone calls most anywhere they travel. Moreover, as cellular telephone technology is increased, so too has the functionality of cellular devices. For example, many cellular devices now incorporate Personal Digital Assistant (PDA) features such as calendars, address books, task lists, calculators, memo and writing programs, etc. These multi-function devices usually allow users to wirelessly send and receive electronic mail (email) messages and access the internet via a cellular network and/or a wireless local area network (WLAN), for example.

As the functionality of cellular communications devices continues to increase, so too does demand for smaller devices that are easier and more convenient for users to carry. As any circuit boards and electronic components thereon are reduced in size and placed closer together, including antenna and other RF components, including power amplifiers and antenna switches, various electronic components can pick up conductive energy and create interference within the system. For example, some components could pick up conducted energy directly from a power amplifier or from the radiated energy emitted by an antenna. This unwanted reception of conducted/near field radiated energy from power amplifiers and antennae is particularly problematic in a packet burst transmission as part of a Global System for Mobile communications (GSM) system, including the 450 MHz, 900 MHz, 1800 MHz and 1900 MHz frequency band.

Some mobile wireless communications devices have an RF metal shield also termed a "can" that forms a compartment on a circuit board and receives RF circuitry therein, for example, the power amplifier and antenna switch, typically a diplexer antenna switch also termed a transmit/receiver antenna switch. One or more RF shields as metallic "cans" can form radio frequency isolation compartments that may include a transceiver chip set in one "can" and the power amplifier and antenna switch in another "can" to aid RF filtering between the RF power amplifier and the antenna switch. Some signal coupling through the RF shield as created from voltage standing waves of single or multiple harmonics, thus bypassing various components such as filters that are formed to prevent such coupling.

US 2007273602 discloses a mobile wireless communications device including a housing and circuit board carried by the housing and having RF circuitry comprising at least one RF component and plurality of other components mounted on the circuit board. An RF metal shield is secured to the circuit board and surrounds and isolates the at least one RF component and plurality of other components within the RF metal shield. An RF absorber is positioned adjacent an area of the RF component that radiates energy to aid in reducing energy radiated from the RF component into the RF metal shield.

EP 0279137 discloses a dissipative low-pass filter comprising a series branch formed by an inductance coil (L) in parallel with a resistor (R1) and a parallel branch formed by a capacitor (C) in series with a resistor (Rc). For frequencies such that Rc is much greater than 1/omega C and R1 is much less than omega L, the ratio between the output and input powers of the filter has a predetermined maximum value strictly lower than 1 and independent of the load impedance.

### Summary of the Invention

The invention is defined in the independent claims. Some optional features of the invention are defined in the dependent claims.

In accordance with one non-limiting aspect, a mobile wireless communications device includes a housing and antenna supported by the housing. A circuit board is carried by the housing and has radio frequency (RF) circuitry operative with the antenna for receiving and transmitting RF signals through the antenna. A power amplifier is connected within a transmission line for amplifying RF signals to be transmitted over the transmission line to the antenna. An antenna switch is carried by a circuit board and connected to the antenna for switching between receiving and transmitting RF signals to the antenna. An RF shield surrounds the power amplifier and antenna switch for isolating the power amplifier and antenna switch from the antenna and RF circuitry. In accordance with a non-limiting example, a low pass filter is formed within the transmission line and has an input connected to the power amplifier and an output connected to the antenna switch for reducing any RF coupling of voltage standing waves of upper harmonic frequencies from the power amplifier into the antenna switch between the input and output of the low pass filter through the RF shield while maintaining transmission of signals through the.transmission line at a desired fundamental frequency.

In one aspect, a low pass filter can be formed as an RLC filter and formed using a capacitor and first resistor connected in a series and an inductor and second resistor connected in parallel. The low pass filter could also include a grounded resistor in series with a first capacitor and a grounded second capacitor in parallel with the first capacitor. The values for each capacitor, resistor inductor can be chosen such that at a fundamental frequency, the impedance of the capacitance is higher than the first resistor, and the impedance of the inductor is lower than the second resistor. At higher harmonic frequencies, the impedance of the capacitor is reduced and the first resistor becomes a dominant element for reducing any RF coupling of voltage standing waves of upper harmonic frequencies from the power amplifier into the antenna switch between the input and output of the low pass filter through the RF shield while maintaining transmission of signals through the transmission line at a desired fundamental frequency.

In another aspect, the RF shield is formed as a metal housing secured to a circuit board and surrounding the power amplifier and antenna switch, which can be positioned within an isolation compartment on the circuit board. The RF shield surrounds the power amplifier and antenna switch and can be positioned over the isolation compartment and secured to the circuit board. The RF circuitry can be operative for generating Global System for Mobile (GSM) packet bursts. The RF circuitry can be formed as a transceiver chip set.

A method aspect is also set forth.

### Brief Description of the Drawings

Other objects, features and advantages will become apparent from the detailed description which follows, when considered in light of the accompanying drawings in which:

FIG. 1 is a schematic block diagram of an example of a mobile wireless communications device configured as a handheld device and illustrating basic internal components thereof.

FIG. 2 is a front elevation view of the mobile wireless communications device of FIG. 1.

FIG. 3 is a schematic block diagram showing basic functional circuit components that can be used in the mobile wireless communications device of FIGS. 1-2.

FIG. 4 is front elevational view of the mobile wireless communications device in accordance with one embodiment having the front cover removed to illustrate an example of RF circuitry, power amplifier, surface mounted microphone and noise isolation components associated thereof.

FIG. 5 is a fragmentary, side elevation view showing the RF shield on the printed circuit board and showing in schematic representation the RF coupling between the input and output of a typical LC low pass filter via the RF shield because of standing waves at harmonic frequencies.

FIG. 6 is a schematic circuit diagram of the circuit shown in FIG. 5 and showing a typical LC low pass harmonic filter and the input and output standing waves resulting from a mismatch at harmonic frequencies.

FIG. 7 is a graph showing the corresponding return loss and plot of an LC low pass harmonic filter over fundamental and harmonic frequencies for the circuit of FIGS. 5 and 6.

FIG. 8 is a graph showing a corresponding insertion loss plot of an LC low pass harmonic filter over fundamental and harmonic frequencies for the circuit of FIGS. 5 and 6.

FIG. 9 is a schematic circuit diagram showing an RLC low pass harmonic filter that results in an improvement of input and output standing waves at harmonic frequencies.

FIG. 10 is a graph showing the corresponding return loss plot of the RLC low pass harmonic filter over fundamental and harmonic frequencies based upon the circuit shown in FIG. 9.

FIG. 11 is a graph showing the corresponding insertion loss plot of the RLC low pass harmonic filter over fundamental and harmonic frequencies.

### Detailed Description of the Preferred Embodiments

The present description is made with reference to the accompanying drawings, in which preferred embodiments are shown. However, many different embodiments may be used, and thus the description should not be construed as limited to the embodiments set forth herein. Rather, these embodiments are provided so that this disclosure will be thorough and complete. Like numbers refer to like elements throughout.

Typically, a low pass filter exists between the power amplifier and antenna switch. An RF shield such as a metallic "can" encases the power amplifier and antenna switch and includes therein a three-pole LC filter in the middle of the power amplifier and antenna switch transmission line. In the tight physical space under the RF "can", the transmission line can be mismatched at harmonic frequencies and create significant standing waves. The RF shield couples the RF harmonics from a power amplifier output directly to the antenna switch input, causing problems such that signals bypass any low pass filter. This RF coupling because of the RF shield is created by the high RF voltage standing wave ratio (VSWR).

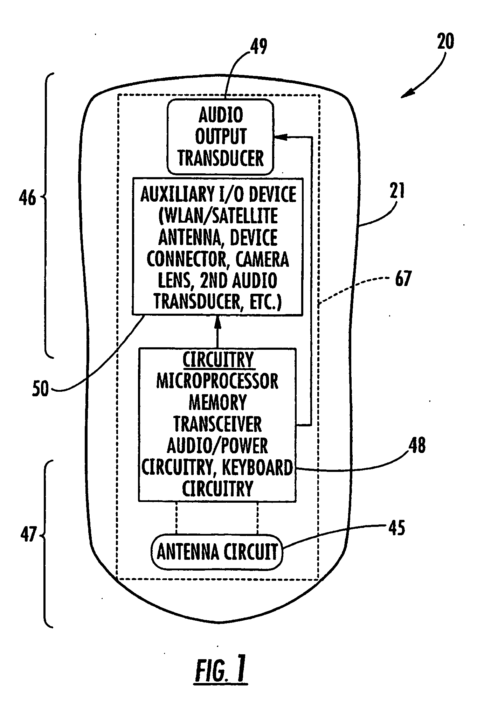

A brief description will now proceed relative to FIGS. 1-3, which disclose an example of a mobile wireless communications device, for example, a handheld portable cellular radio, which can incorporate the non-limiting examples of the various circuits as later described. FIGS. 1-3 are representative non-limiting examples of the many different types of functional circuit components and their interconnection, and operative for use with the circuits as described.

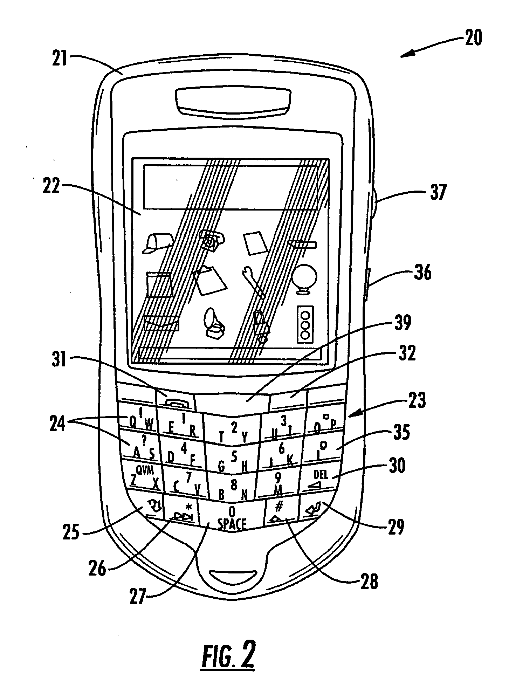

Referring initially to FIGS. 1 and 2, an example of a mobile wireless communications device **20,** such as a handheld portable cellular radio that can incorporate the low pass filter as described below is set forth. This device **20** illustratively includes a housing **21** having an upper portion **46** and a lower portion **47,** and at least one dielectric substrate (i.e., circuit board) **67,** such as a conventional printed circuit board (PCB) substrate, for example, carried by the housing. A number of different circuit boards can be used for supporting different components. A housing cover (not shown in detail) would typically cover the front portion of the housing. The term circuit board **67** as used hereinafter can refer to any dielectric substrate, PCB, ceramic substrate or other circuit carrying structure for carrying signal circuits and electronic components within the mobile wireless communications device **20.** The illustrated housing **21** is a static housing, for example, but it should be understood that a flip or sliding housing can be used as is typical in many cellular and similar telephones. These and other housing configurations may also be used.

Circuitry **48** is carried by the circuit board **67,** such as a microprocessor, memory, one or more wireless transceivers (e.g., cellular, WLAN, etc.), which includes RF circuitry, including audio and power circuitry, including any keyboard circuitry. This circuitry could also generally be termed RF circuitry. It should be understood that keyboard circuitry could be on a separate keyboard, etc., as will be appreciated by those skilled in the art. The different components as described can also be distributed on one circuit board or among a plurality of circuit boards. A battery (not shown) is also preferably carried by the housing **21** for supplying power to the circuitry **48.** The term RF circuitry could encompass the interoperable RF transceiver circuitry, including receive and transmit circuits and power circuitry and audio circuitry.

In one aspect, an audio output transducer **49** (e.g., a speaker) is carried by an upper portion **46** of the housing **21** and connected to the circuitry **48.** One or more user input interface devices, such as a keypad (keyboard) **23** (FIG. 2), is also preferably carried by the housing **21** and connected to the RF circuitry **48.** The term keypad as used herein also refers to the term keyboard, indicating the user input devices having lettered and/or numbered keys commonly known and other embodiments, including multi-top or predictive entry modes. Other examples of user input interface devices include a scroll wheel **37** and a back button **36.** Of course, it will be appreciated that other user input interface devices (e.g., a stylus or touch screen interface) may be used in other embodiments.

An antenna **45** is preferably supported within the housing and in one aspect at a lower portion **47** in the housing. The antenna can be formed as a pattern of conductive traces that make an antenna circuit, which physically forms the antenna. It is operatively connected to the circuitry **48** on the main circuit board **67.** In one non-limiting example, the antenna could be formed on an antenna circuit board section that extends from the circuit board at the lower portion of the housing. By placing the antenna **45** adjacent the lower portion **47** of the housing **21,** the distance is advantageously increased between the antenna and the user's head when the phone is in use to aid in complying with applicable SAR requirements. Also, a separate keyboard circuit board could be used.

More particularly, a user will typically hold the upper portion of the housing **21** very close to their head so that the audio output transducer **49** is directly next to the ear. Yet, the lower portion **47** of the housing **21** where an audio input transducer (i.e., microphone) is located need not be placed directly next to a user's mouth, and can be held away from the user's mouth. That is, holding the audio input transducer close to the user's mouth may not only be uncomfortable for the user, but it may also distort the user's voice in some circumstances. In addition, the placement of the antenna **45** adjacent the lower portion **47** of the housing **21** also advantageously spaces the antenna farther away from the user's brain.

In some designs, the antenna **45** is placed adjacent the lower portion **47** of the housing **21** to allow for less impact on antenna performance due to blockage by a user's hand. Users typically hold cellular phones towards the middle to upper portion of the phone housing, and are therefore more likely to put their hands over such an antenna than they are an antenna mounted adjacent the lower portion **47** of the housing **21.** Accordingly, more reliable performance may be achieved from placing the antenna **45** adjacent the lower portion **47** of the housing **21.**

Another benefit of this type of configuration is that it provides more room for one or more auxiliary input/output (I/O) devices **50** to be carried at the upper portion **46** of the housing. Furthermore, by separating the antenna **45** from the auxiliary I/O device(s) **50,** this may allow for reduced interference therebetween.

Some examples of auxiliary I/O devices **50** include a WLAN (e.g., Bluetooth, IEEE 802.11) antenna for providing WLAN communication capabilities, and/or a satellite positioning system (e.g., GPS, Galileo, etc.) antenna for providing position location capabilities, as will be appreciated by those skilled in the art. Other examples of auxiliary I/O devices **50** include a second audio output transducer (e.g., a speaker for speaker phone operation), and a camera lens for providing digital camera capabilities, an electrical device connector (e.g., USB, headphone, secure digital (SD) or memory card, etc.).

It should be noted that the term "input/output" as used herein for the auxiliary I/O device(s) 50 means that such devices may have input and/or output capabilities, and they need not provide both in all embodiments. That is, devices such as camera lenses may only receive an optical input, for example, while a headphone jack may only provide an audio output.

The device **20** further illustratively includes a display **22,** for example, a liquid crystal display (LCD) carried by the housing **21** and connected to the circuitry **48.** A back button **36** and scroll wheel **37** can also be connected to the circuitry **48** for allowing a user to navigate menus, text, etc., as will be appreciated by those skilled in the art. The scroll wheel **37** may also be referred to as a "thumb wheel" or a "track wheel" in some instances. The keypad **23** illustratively includes a plurality of multi-symbol keys **24** each having indicia of a plurality of respective symbols thereon. The keypad **23** also illustratively includes an alternate function key **25,** a next key **26,** a space key **27,** a shift key **28,** a return (or enter) key **29,** and a backspace/delete key **30.**

The next key **26** is also used to enter a "*" symbol upon first pressing or actuating the alternate function key **25.** Similarly, the space key **27,** shift key **28** and backspace key **30** are used to enter a "0" and "#", respectively, upon first actuating the alternate function key **25.** The keypad **23** further illustratively includes a send key **31,** an end key **32,** and a convenience (i.e., menu) key **39** for use in placing cellular telephone calls, as will be appreciated by those skilled in the art.

Moreover, the symbols on each key **24** are arranged in top and bottom rows. The symbols in the bottom rows are entered when a user presses a key **24** without first pressing the alternate function key **25,** while the top row symbols are entered by first pressing the alternate function key. As seen in FIG. 2, the multi-symbol keys **24** are arranged in the first three rows on the keypad **23** below the send and end keys **31, 32.** Furthermore, the letter symbols on each of the keys **24** are arranged to define a QWERTY layout. The letters on the keypad **23** are presented in a three-row format, with the letters of each row being in the same order and relative position as in a standard QWERTY keypad.

Each row of keys (including the fourth row of function keys **25-29**) is arranged in five columns in this non-limiting example. The multi-symbol keys **24** in the second, third, and fourth columns of the first, second, and third rows have numeric indicia thereon (i.e., 1 through 9) accessible by first actuating the alternate function key **25.** Coupled with the next, space, and shift keys **26, 27, 28,** which respectively enter a "*", "0", and "#" upon first actuating the alternate function key **25,** as noted above, this set of keys defines a standard telephone keypad layout, as would be found on a traditional touch-tone telephone, as will be appreciated by those skilled in the art.

Accordingly, the mobile wireless communications device **20** as described may advantageously be used not only as a traditional cellular phone, but it may also be conveniently used for sending and/or receiving data over a cellular or other network, such as Internet and email data, for example. Of course, other keypad configurations may also be used in other embodiments. Multi-tap or predictive entry modes may be used for typing e-mails, etc. as will be appreciated by those skilled in the art.

The antenna **45** is preferably formed as a multifrequency band antenna, which provides enhanced transmission and reception characteristics over multiple operating frequencies. More particularly, the antenna **45** is designed to provide high gain, desired impedance matching, and meet applicable SAR requirements over a relatively wide bandwidth and multiple cellular frequency bands. By way of example, in one non-limiting example, the antenna **45** preferably operates over five bands, namely a 850 MHz Global System for Mobile Communications (GSM) band, a 900 MHz GSM band, a DCS band, a PCS band, and a WCDMA band (i.e., up to about 2100 MHz), although it may be used for other bands/frequencies as well. To conserve space, the antenna **45** may advantageously be implemented in three dimensions although it may be implemented in two-dimensional or planar embodiments as well.

The mobile wireless communications device shown in FIGS. 1 and 2 can incorporate e-mail and messaging accounts and provide different functions such as composing e-mail, PIN messages, and SMS messages. The device can manage messages through an appropriate menu that can be retrieved by choosing a messages icon. An address book function could add contacts, allow management of an address book, set address book options and manage SIM card phone books. A phone menu could allow for the making and answering of phone calls using different phone features, managing phone call logs, setting phone options, and viewing phone information. A browser application could permit the browsing of web pages, configuring a browser, adding bookmarks, and changing browser options. Other applications could include a task, memo pad, calculator, alarm and games, as well as handheld options with various references.

A calendar icon can be chosen for entering a calendar program that can be used for establishing and managing events such as meetings or appointments. The calendar program could be any type of messaging or appointment/meeting program that allows an organizer to establish an event, for example, an appointment or meeting.

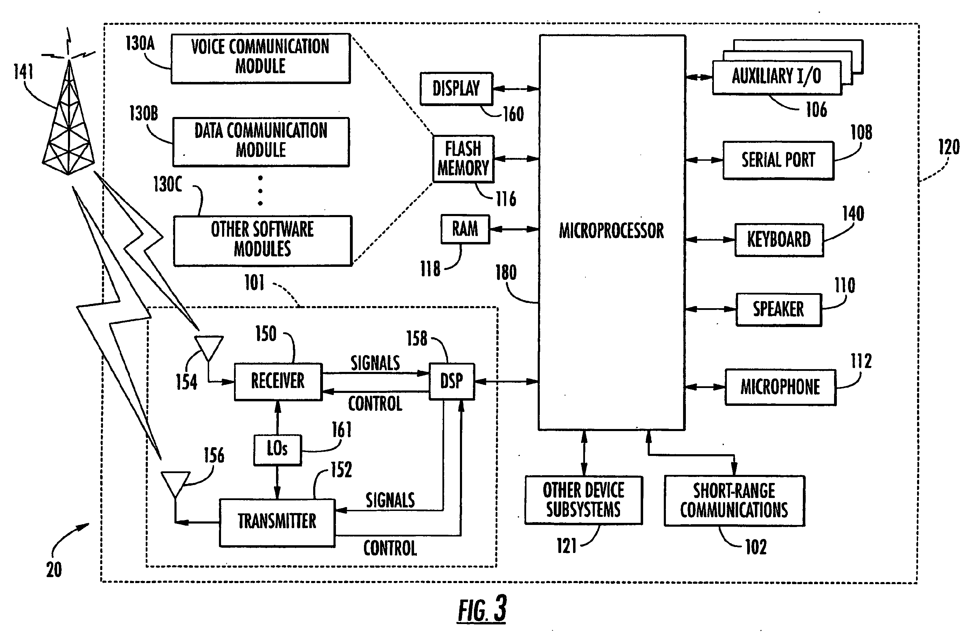

A non-limiting example of various functional components that can be used in the exemplary mobile wireless communications device **20** of FIGS. 1 and 2 is further described in the example below with reference to FIG. 3. The device **20** illustratively includes a housing **120,** a keypad **140** and an output device **160.** The output device **160** shown is preferably a display, which is preferably a full graphic LCD. Other types of output devices may alternatively be used. A processing device **180** is contained within the housing **120** and is coupled between the keypad **140** and the display **160.** The processing device **180** controls the operation of the display **160,** as well as the overall operation of the mobile device **20,** in response to actuation of keys on the keypad **140** by the user.

The housing **120** may be elongated vertically, or may take on other sizes and shapes (including clamshell housing structures). The keypad may include a mode selection key, or other hardware or software for switching between text entry and telephony entry.

In addition to the processing device **180,** other parts of the mobile device **20** are shown schematically in FIG. 3. These include a communications subsystem **101;** a short-range communications subsystem **102;** the keypad **140** and the display **160,** along with other input/output devices **106, 108, 110** and **112;** as well as memory devices **116, 118** and various other device subsystems **121.** The mobile device **20** is preferably a two-way RF communications device having voice and data communications capabilities. In addition, the mobile device **20** preferably has the capability to communicate with other computer systems via the Internet.

Operating system software executed by the processing device **180** is preferably stored in a persistent store, such as the flash memory **116,** but may be stored in other types of memory devices, such as a read only memory (ROM) or similar storage element. In addition, system software, specific device applications, or parts thereof, may be temporarily loaded into a volatile store, such as the random access memory (RAM) **118.** Communications signals received by the mobile device may also be stored in the RAM **118.**

The processing device **180,** in addition to its operating system functions, enables execution of software applications **130A-130N** on the device **20.** A predetermined set of applications that control basic device operations, such as data and voice communications **130A** and **130B,** may be installed on the device **20** during manufacture. In addition, a personal information manager (PIM) application may be installed during manufacture. The PIM is preferably capable of organizing and managing data items, such as e-mail, calendar events, voice mails, appointments, and task items. The PIM application is also preferably capable of sending and receiving data items via a wireless network **141.** Preferably, the PIM data items are seamlessly integrated, synchronized and updated via the wireless network **141** with the device user's corresponding data items stored or associated with a host computer system.

Communication functions, including data and voice communications, are performed through the communications subsystem **101,** and possibly through the short-range communications subsystem. The communications subsystem **101** includes a receiver **150,** a transmitter **152,** and one or more antennae **154** and **156.** In addition, the communications subsystem **101** also includes a processing module, such as a digital signal processor (DSP) **158,** and local oscillators (LOs) **161.** The specific design and implementation of the communications subsystem **101** is dependent upon the communications network in which the mobile device **20** is intended to operate. For example, the mobile device **20** may include a communications subsystem **101** designed to operate with the Mobitex^{™}, Data TAC^{™} or General Packet Radio Service (GPRS) mobile data communications networks, and also designed to operate with any of a variety of voice communications networks, such as AMPS, TDMA, CDMA, PCS, GSM, etc. Other types of data and voice networks, both separate and integrated, may also be utilized with the mobile device **20.**

Network access requirements vary depending upon the type of communication system. For example, in the Mobitex and DataTAC networks, mobile devices are registered on the network using a unique personal identification number or PIN associated with each device. In GPRS networks, however, network access is associated with a subscriber or user of a device. A GPRS device therefore requires a subscriber identity module, commonly referred to as a SIM card, in order to operate on a GPRS network.

When required network registration or activation procedures have been completed, the mobile device **20** may send and receive communications signals over the communication network **141.** Signals received from the communications network **141** by the antenna **154** are routed to the receiver **150,** which provides for signal amplification, frequency down conversion, filtering, channel selection, etc., and may also provide analog to digital conversion. Analog-to-digital conversion of the received signal allows the DSP **158** to perform more complex communications functions, such as demodulation and decoding. In a similar manner, signals to be transmitted to the network **141** are processed (e.g., modulate and encoded) by the DSP **158** and are then provided to the transmitter **152** for digital to analog conversion, frequency up conversion, filtering, amplification and transmission to the communication network **141** (or networks) via the antenna **156.**

In addition to processing communications signals, the DSP **158** provides for control of the receiver **150** and the transmitter **152.** For example, gains applied to communications signals in the receiver **150** and transmitter **152** may be adaptively controlled through automatic gain control algorithms implemented in the DSP **158.**

In a data communications mode, a received signal, such as a text message or web page download, is processed by the communications subsystem **101** and is input to the processing device **180.** The received signal is then further processed by the processing device **180** for an output to the display **160,** or alternatively to some other auxiliary I/O device **106.** A device user may also compose data items, such as e-mail messages, using the keypad **140** and/or some other auxiliary I/O device **106,** such as a touchpad, a rocker switch, a thumb-wheel, or some other type of input device. The composed data items may then be transmitted over the communications network **141** via the communications subsystem **101.**

In a voice communications mode, overall operation of the device is substantially similar to the data communications mode, except that received signals are output to a speaker **110,** and signals for transmission are generated by a microphone **112.** Alternative voice or audio I/O subsystems, such as a voice message recording subsystem, may also be implemented on the device **20.** In addition, the display **160** may also be utilized in voice communications mode, for example to display the identity of a calling party, the duration of a voice call, or other voice call related information.

Any short-range communications subsystem enables communication between the mobile device **20** and other proximate systems or devices, which need not necessarily be similar devices. For example, the short-range communications subsystem may include an infrared device and associated circuits and components, or a Bluetooth™ communications module to provide for communication with similarly-enabled systems and devices.

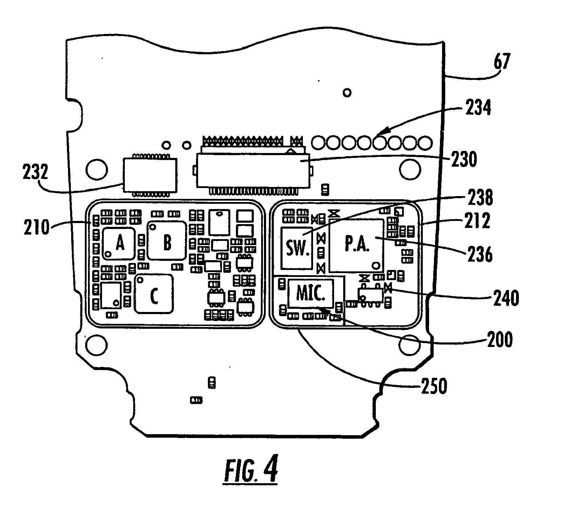

In accordance with a non-limiting example, FIG. 4 shows an example of a circuit layout on part of the circuit board **67** that can be included within the mobile wireless communications device **20** of FIGS. 1-3, and showing a front cover removed from a housing to illustrate a surface mounted microphone **200** and its circuitry and associated noise isolation components as will be explained in greater detail below. The circuit board **67** includes the radio frequency (RF) circuitry **48,** for example, cellular telephone communications circuitry, which is mounted in first and second isolation shields or "cans" **210,212,** as often called by those skilled in the art, forming a compartment on the circuit board, each which receive the RF circuitry. Each can **210,212** forms a radio frequency isolation compartment and may include sides and a top. The first can **210** in one non-limiting example includes a transceiver chip set **220,** for example, a transmitter chip, receiver chip, and local oscillator chip as non-limiting examples with those chips labeled A, B and C. Other illustrated components could include the various resistors, capacitors, amplifiers, regulators and other circuit components common to those devices, but not explained in detail.

Located outside first and second isolation cans **210,212,** in this non-limiting example but mounted on the circuit board **67,** is a liquid crystal display (LCD) connector **230** and a keyboard connector **232,** as well as associated circuit components **234.** These components **230, 232** and **234** can be configured in different configurations besides the configuration illustrated in the non-limiting example of FIG. 4. The compartment within the second isolation can **212** includes a power amplifier **236** and switch diplexer **238** as an antenna switch through which RF signals are transmitted and received and connected by a transmission line with the low pass filter as described in greater detail below. Other components **240** are mounted within the compartment and form the resistors, capacitors, transistors, and inductors necessary to drive the audio and power circuits for the microphone, power amplifier and other RF circuits.

In one non-limiting example, a radio frequency isolation shield, formed in the illustrated non-limiting example as a third isolation "can" **250,** is positioned at a corner of the second "can" **212,** and forms another isolation compartment at this corner to provide microphone isolation. The RF shield **212** in one aspect is formed as a separate metallic housing secured to the circuit board. The smaller RF shield **250** surrounds the microphone, effectively covering, i.e., shielding the entire microphone. That shield can be similarly formed to other shields. Although a "can" configuration formed as a metallic housing with top and sides is used for the RF shields **210, 212,** other configurations could be used. Each RF shield as a metallic "can" forms a compartment on the circuit board in one non-limiting example.

As noted before relative to the description of FIG. 4, the power amplifier **236** and switch **238** are contained within the RF metal shield **212** forming a can to isolate the power amplifier and switch.

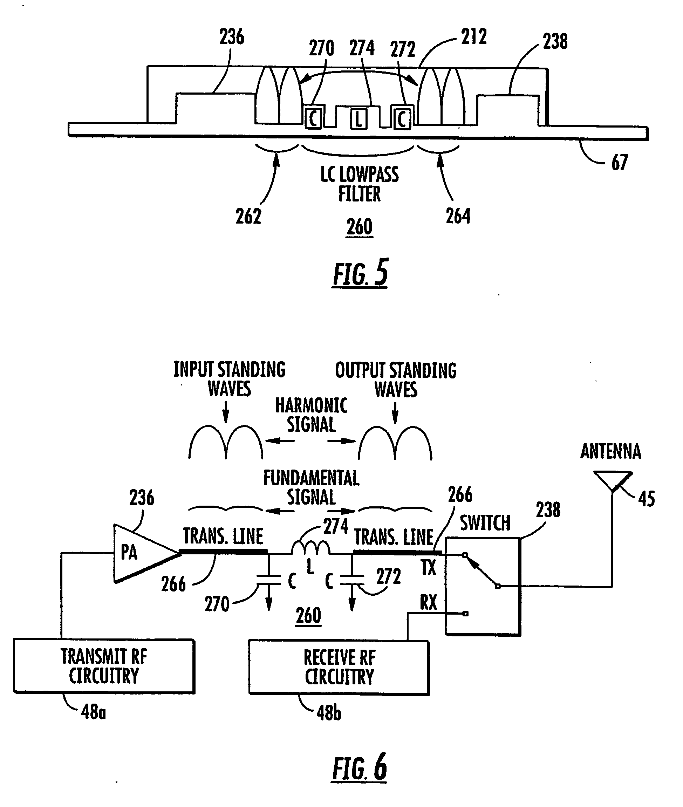

FIG. 5 is the fragmentary drawing representation looking in a side elevation view and showing the "can" **212** and a typical LC low pass filter **260** that includes an input **262** and output **264** as input and output transmission lines that form the transmission line **266** between the power amplifier **236** and antenna switch **238** as positioned on the printed circuit board **67.** As shown in FIG. 6, the RF circuitry can include transmit RF circuitry **48A** and receive RF circuitry **48B** that connect to the switch **238.** The transmit RF circuitry **48A** includes the transmission line **266** to which the power amplifier **236** connects. The LC low pass filter **260** is connected into the transmission line **266** between the power amplifier **236** and antenna switch **238** and is formed as first and second parallel capacitors **270, 272,** and a series connected inductor **274** in-line with the transmission line **266.**

The LC low pass filter **260** shown in FIG. 5 and FIG. 6 is implemented to provide RF filtering between the RF power amplifier **236** and the antenna switch **238,** that operating typically as a transmit and receive antenna switch. This filter is typically designed as a 3-pole LC filter as shown in the middle of the transmission line **266.** These components are placed in a tight physical space under the RF shield **212** and this transmission line **266** often can be mismatched at harmonic frequencies and create a significant standing wave.

It should be understood that the standing wave ratio (SWR) is a ratio of the amplitude of a partial standing wave at an antinode (maximum) to the amplitude and adjacent node (minimum) in the transmission line. It is usually a voltage ratio called the voltage standing wave ratio (VSWR). There is typically a forward wave with an amplitude superimposed on a reflected wave. These reflections occur because of discontinuities, for example, imperfections in the transmission line or termination points with other than a characteristic impedance. Sometimes two waves can interfere constructively. The SWR is an indicator of the reflected waves bouncing back and forth within a transmission line and could correspond to an increase in power in the line beyond the actual transmitted power and create an increase in RF losses as the increased voltage increases dielectric losses, and the increased current increases resistive losses. Of course, a matched impedance gives an ideal power transfer while mismatched impedances give high SWR and increased losses in the transmission line. Usually, some reflected power in the transmission line is reflected back at the transmitter and radiated by the antenna. Typically, a Smith chart showing a graph can express the reflection coefficient such that a magnitude of zero is a perfect match, and a value of one is a perfect reflection in some non-limiting examples. Of course, the reflection coefficient can distinguish between short and open circuits where a short circuit has a value of -1 while an open circuit has an angle of zero degrees. The return loss of a load with a magnitude of the reflection coefficient is typically expressed in decibels. Return loss is typically a positive number.

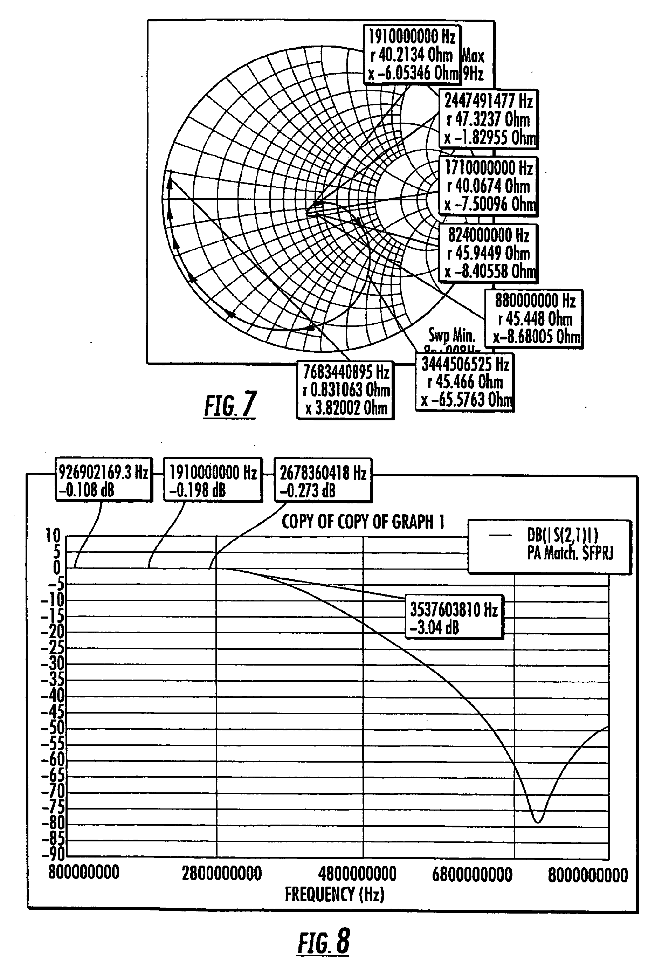

As a result, because of the standing waves, the RF shield **212** couples the RF harmonics from the power amplifier **236** output directly to the switch input **238** and bypasses the low pass filter **260.** This RF coupling is created by the high RF voltage standing wave ratio (VSWR) such as shown in the Smith chart of FIG. 7. The graph shows the corresponding return loss (S11) plot of the LC low pass harmonic filter **260** over fundamental and harmonic frequencies. FIG. 8 is a graph showing the corresponding insertion loss (S21) plot of the same LC low pass harmonic filter **260** over fundamental and harmonic frequencies. FIG. 6 shows the input standing waves and output standing waves as part of the harmonic signal and the fundamental signal.

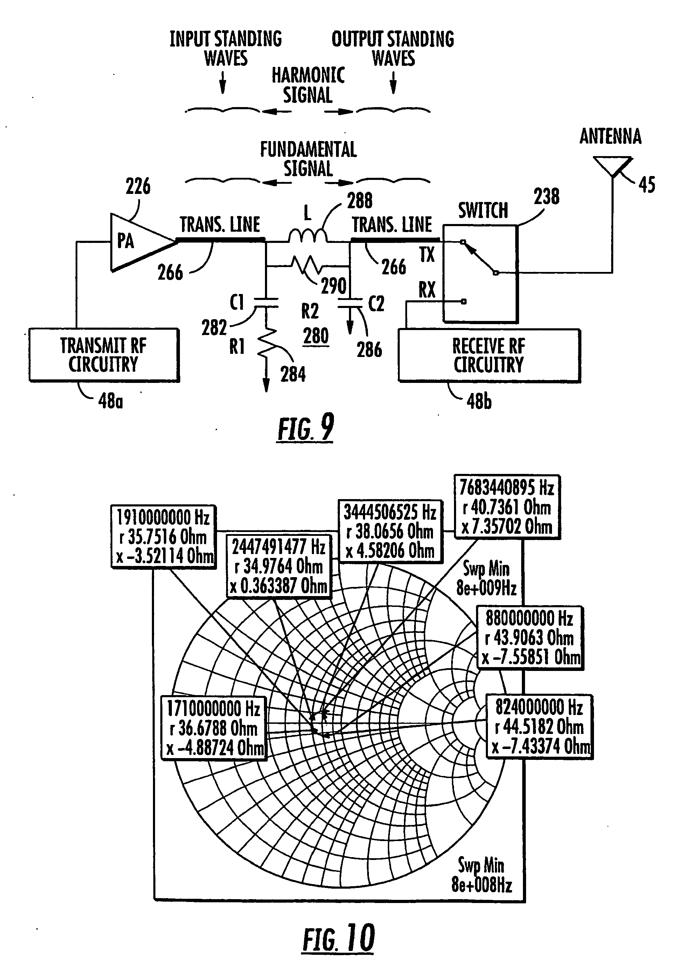

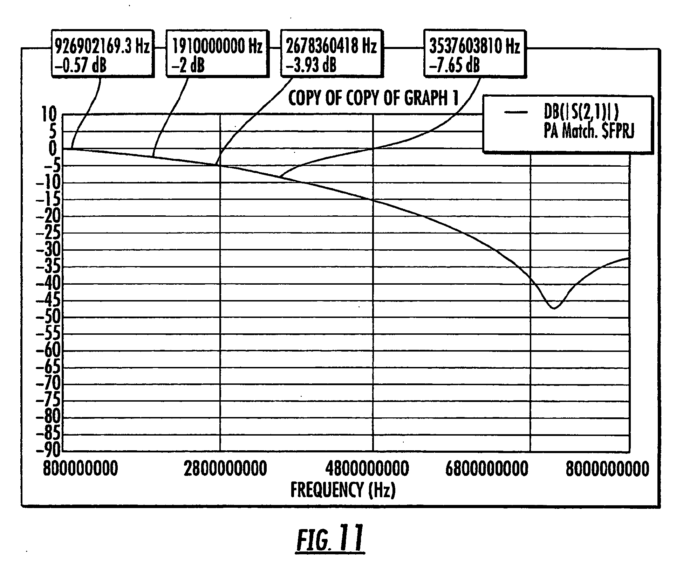

In accordance with the non-limiting example, FIG. 9 shows a low pass filter that solves the technical problem addressed above by using an RLC lossy low pass filter **280** that significantly reduces the voltage standing wave ratio (VSWR) at harmonic frequencies, such as shown in the Smith chart of FIG. 10. The graph displays the corresponding return loss (S11) plot of the RLC low pass harmonic filter **280** over fundamental and harmonic frequencies. As illustrated, the RLC low pass filter **280** includes a first capacitor **282** series connected to a ground connected first resistor **284,** which are in parallel with a second ground connected capacitor **286.** The inductor **288** is serially connected within the transmission line **266.** A second resistor **290** is connected in parallel to the inductor **288.** These various components are selected to have resistance, capacitance, and inductance values such that at a fundamental frequency, the impedance of the capacitance established by the capacitors **282, 286** is higher than the first resistor **284** and the impedance of the inductor **288** is lower than the second resistor **290.** At higher harmonic frequencies, the impedance of the capacitor **282** is reduced, and the first resistor **284** becomes a dominant element for reducing any RF coupling of voltage standing waves of upper harmonic frequencies from the power amplifier **226** into the antenna switch **238** between the input and output of the low pass filter **280** through the RF metal shield **212** while maintaining transmission of RF signals through the transmission line **266** at a desired fundamental frequency. R1 and R2 **284, 290** have a minimum effect to the performance of the low pass filter, i.e., the insertion loss. At the higher harmonic frequencies, as noted before, the impedance of the first capacitor **282** is reduced significantly, and the first resistor **284** becomes the dominating element. The same is true relative to the second resistor **290,** which is relatively lower in impedance than that of the inductor **288.** Thus, the RLC low pass filter **280** as described becomes a more dissipative filter at its input, which results in a very low voltage standing wave ratio (VSWR) as shown in FIG. 10. The corresponding insertion loss (S21) plot of the RLC low pass harmonic filter **280** over fundamental and harmonic frequencies is shown in the graph of FIG. 11.

As a result, the RF shield no longer couples RF harmonics when the power amplifier output is directly output to the switch input.

Many modifications and other embodiments will come to the mind of one skilled in the art having the benefit of the teachings presented in the foregoing descriptions and the associated drawings. Therefore, it is understood that various modifications and embodiments are intended to be included within the scope of the appended claims.

## Claims

1. A mobile wireless communications device (20), comprising:
a housing (21);
an antenna (45) supported by the housing;
a circuit board (67) carried by the housing and having radio frequency (RF) circuitry operative with the antenna for receiving and transmitting RF signals through the antenna, the circuitry including a transmission line (266) and power amplifier (226) for amplifying RF signals to be transmitted over the transmission line to the antenna;
an antenna switch (238) carried by the circuit board and connected to said antenna and RF circuitry for switching between receiving and transmitting RF signals through the antenna;
an RF metal shield (212) surrounding said power amplifier and antenna switch for isolating said power amplifier and antenna switch from said antenna and RF circuitry; and
wherein the mobile wireless communications device further comprises a RLC low pass filter (280) connected within the transmission line, the RLC low pass filter having an input connected to said power amplifier and an output connected to said antenna switch and the RLC low pass filter being for reducing any RF coupling of Voltage Standing Waves of upper harmonic frequencies from the power amplifier into the antenna switch through the RF shield while maintaining transmission of signals through the transmission line at a desired fundamental frequency.

2. The mobile wireless communications device according to Claim 1, wherein said RLC filter comprises a capacitor (282) and first resistor (284) connected in series and an inductor (288) and second resistor (290) connected in parallel.

3. The mobile wireless communications device according to Claim 2, wherein said RLC low pass filter comprises a grounded resistor in series with a first capacitor and a grounded second capacitor (286) in parallel with the first capacitor.

4. The mobile wireless communications device according to Claim 1, wherein said RF shield comprises a metallic housing secured to said at least one circuit board and surrounding said power amplifier and antenna switch.

5. The mobile wireless communications device according to Claim 4 and further comprising an isolation compartment in which said power amplifier and antenna switch are positioned.

6. The mobile wireless communications device of claim 1
wherein said RLC low pass filter has an input connected to said power amplifier and an output connected to said antenna switch, said RLC low pass filter further comprising a capacitor (282) and first resistor (284) in series and an inductor (288) and second resistor (290) in parallel and having resistance, inductance, and capacitance values such that at a fundamental frequency the impedance of the capacitor is higher than the first resistor and the impedance of the inductor is lower than the second resistor and at higher harmonic frequencies the impedance of the capacitor is reduced and the first resistor becomes a dominant element for reducing any RF coupling of Voltage Standing Waves of upper harmonic frequencies from the power amplifier into the antenna switch through the RF metal shield while maintaining transmission of signals through the transmission line at a desired fundamental frequency.

7. The mobile wireless communications device according to Claim 6, wherein said RLC low pass filter comprise a grounded resistor in series with a first capacitor and a grounded second capacitor (286) in parallel with the first capacitor.

8. The mobile wireless communications device according to Claim 6, wherein said RF shield comprises a metallic housing secured to said at least one circuit board and surrounding said power amplifier and antenna switch.

9. The mobile wireless communications device according to Claim 6, and further comprising an isolation compartment in which said power amplifier and antenna switch are positioned.

10. A method of operating a mobile wireless communications device (20), which comprises:
providing a housing (21), an antenna (45) supported by the housing, a circuit board (67) carried by the housing and having radio frequency (RF) circuitry operative with the antenna for receiving and transmitting RF signals through the antenna, the circuitry including a transmission line (266) and power amplifier (226) for amplifying RF signals to be transmitted over the transmission line to the antenna;
switching between receiving and transmitting RF signals through the antenna using an antenna switch (238); and
isolating the power amplifier and antenna switch from the antenna and RF circuitry by surrounding the power amplifier and antenna switch with an RF metal shield (212) and;
reducing any RF coupling of Voltage Standing Waves of upper harmonic frequencies from the power amplifier into the antenna switch through the RF shield using a RLC low pass filter (280) positioned within the transmission line while maintaining transmission of signals through the transmission line at a desired fundamental frequency.

11. The method according to Claim 10, which further comprises, forming a capacitor (282) and first resistor (284) in series and an inductor (288) and second resistor (290) in parallel.

12. The method according to Claim 10, which further comprises, forming a grounded resistor in series with a first capacitor and a grounded second capacitor (286) in parallel with the first capacitor.

## Patentansprüche

1. Mobile drahtlose Kommunikationsvorrichtung (20), die aufweist:
ein Gehäuse (21);
eine Antenne (45), die von dem Gehäuse getragen wird;
eine Leiterplatte (67), die in dem Gehäuse aufgenommen ist und Funkfrequenz(RF - radio frequency)-Schaltungen hat, die mit der Antenne betriebsfähig sind, zum Empfangen und Senden von RF-Signalen über die Antenne, wobei die Schaltungen eine Übertragungsleitung (266) und einen Leistungsverstärker (226) zum Verstärken von RF-Signalen umfassen, die über die Übertragungsleitung an die Antenne zu übertragen sind;
einen Antennenschalter (238), der von der Leiterplatte getragen wird und mit der Antenne und den RF-Schaltungen verbunden ist zum Umschalten zwischen einem Empfangen und einem Senden der RF-Signale über die Antenne;
eine RF-Metallabschirmung (212), die den Leistungsverstärker und den Antennenschalter umgibt, zum Isolieren des Leistungsverstärkers und des Antennenschalters von der Antenne und den RF-Schaltungen; und
wobei die mobile drahtlose Kommunikationsvorrichtung weiter einen RLC-Tiefpaßfilter (280) aufweist, der in der Übertragungsleitung verbunden ist,
wobei der RLC-Tiefpaßfilter einen Eingang hat, der mit dem Leistungsverstärker verbunden ist, und einen Ausgang, der mit dem Antennenschalter verbunden ist, und wobei der RLC-Tiefpaßfilter vorgesehen ist zum Reduzieren einer RF-Kopplung von stehenden Spannungswellen von oberen harmonischen Frequenzen von dem Leistungsverstärker in den Antennenschalter durch die RF-Abschirmung bei einer Beibehaltung der Übertragung von Signalen über die Übertragungsleitung bei einer gewünschten Grundfrequenz.

2. Mobile drahtlose Kommunikationsvorrichtung gemäß Anspruch 1, wobei der RLC-Filter einen Kondensator (282) und einen ersten Widerstand (284), die in Serie verbunden sind, und einen Induktor (288) und einen zweiten Widerstand (290), die parallel verbunden sind, aufweist.

3. Mobile drahtlose Kommunikationsvorrichtung gemäß Anspruch 2, wobei der RLC-Tiefpaßfilter einen geerdeten Widerstand in Serie mit einem ersten Kondensator und einen geerdeten zweiten Kondensator (286) parallel zu dem ersten Kondensator aufweist.

4. Mobile drahtlose Kommunikationsvorrichtung gemäß Anspruch 1, wobei die RF-Abschirmung ein metallisches Gehäuse aufweist, das an der zumindest einen Leiterplatte angebracht ist und den Leistungsverstärker und den Antennenschalter umgibt.

5. Mobile drahtlose Kommunikationsvorrichtung gemäß Anspruch 5, und weiter aufweisend eine Isolierungskammer, in der sich der Leistungsverstärker und der Antennenschalter befinden.

6. Mobile drahtlose Kommunikationsvorrichtung gemäß Anspruch 1, wobei der RLC-Tiefpaßfilter einen Eingang hat, der mit dem Leistungsverstärker verbunden ist, und einen Ausgang, der mit dem Antennenschalter verbunden ist, wobei der RLC-Tiefpaßfilter weiter einen Kondensator (282) und einen ersten Widerstand (284) in Serie und einen Induktor (288) und einen zweiten Widerstand (290) parallel aufweist und Widerstands-, Induktivitäts- und Kapazitanz-Werte hat derart, dass bei einer Grundfrequenz die Impedanz des Kondensators höher ist als der erste Widerstand und die Impedanz des Induktors niedriger ist als der zweite Widerstand und bei höheren harmonischen Frequenzen die Impedanz des Kondensators reduziert ist und der erste Widerstand ein dominierendes Element wird zum Reduzieren einer RF-Kopplung von stehenden Spannungswellen von oberen harmonischen Frequenzen von dem Leistungsverstärker in den Antennenschalter durch die RF-Metallabschirmung bei einer Beibehaltung einer Übertragung von Signalen über die Übertragungsleitung bei einer gewünschten Grundfrequenz.

7. Mobile drahtlose Kommunikationsvorrichtung gemäß Anspruch 6, wobei der RLC-Tiefpaßfilter einen geerdeten Widerstand in Serie mit einem ersten Kondensator und einen geerdeten zweiten Kondensator (286) parallel zu dem ersten Kondensator aufweist.

8. Mobile drahtlose Kommunikationsvorrichtung gemäß Anspruch 6, wobei die RF-Abschirmung ein metallisches Gehäuse aufweist, das an der zumindest einen Leiterplatte angebracht ist und den Leistungsverstärker und den Antennenschalters umgibt.

9. Mobile drahtlose Kommunikationsvorrichtung gemäß Anspruch 6, und weiter aufweisend eine Isolierungskammer, in der sich der Leistungsverstärker und der Antennenschalter befinden.

10. Verfahren zum Betreiben einer mobilen drahtlosen Kommunikationsvorrichtung (20), das aufweist:
Vorsehen eines Gehäuses (21), einer Antenne (45), die von dem Gehäuse getragen wird, einer Leiterplatte (67), die in dem Gehäuse aufgenommen ist und Funkfrequenz(RF - radio frequency)-Schaltungen hat, die mit der Antenne betriebsfähig sind, zum Empfangen und Senden von RF-Signalen über die Antenne, wobei die Schaltungen eine Übertragungsleitung (266) und einen Leistungsverstärker (226) zum Verstärken von RF-Signalen umfassen, die über die Übertragungsleitung an die Antenne zu übertragen sind;
Umschalten zwischen einem Empfangen und Senden von RF-Signalen über die Antenne unter Verwendung eines Antennenschalters (238); und
Isolieren des Leistungsverstärkers und des Antennenschalters von der Antenne und den RF-Schaltungen durch Umgeben des Leistungsverstärkers und des Antennenschalters mit einer RF-Metallabschirmung (212); und
Reduzieren einer RF-Kopplung von stehenden Spannungswellen von oberen harmonischen Frequenzen von dem Leistungsverstärker in den Antennenschalter durch die RF-Abschirmung unter Verwendung eines RLC-Tiefpaßfilters (280), der in der Übertragungsleitung angeordnet ist, bei einer Beibehaltung der Übertragung von Signalen über die Übertragungsleitung bei einer gewünschten Grundfrequenz.

11. Verfahren gemäß Anspruch 10, das weiter aufweist Ausbilden eines Kondensators (282) und ersten Widerstands (284) in Serie und eines Induktors (288) und zweiten Widerstands (290) parallel.

12. Verfahren gemäß Anspruch 10, das weiter aufweist Ausbilden eines geerdeten Widerstands in Serie mit einem ersten Kondensator und eines geerdeten zweiten Kondensators (286) parallel zu dem ersten Kondensator.

## Revendications

1. Dispositif mobile de communication sans fil (20), comprenant :
un boîtier (21) ;
une antenne (45) supportée par le boîtier ;
une carte de circuits (45) portée par le boîtier et possédant des circuits de radiofréquences (RF) coopérant avec l'antenne pour recevoir et émettre des signaux RF via l'antenne, les circuits comprenant une ligne de transmission (266) et un amplificateur de puissance (226) destiné à amplifier des signaux RF devant être transmis sur la ligne de transmission vers l'antenne ;
un commutateur d'antenne (238) porté par la carte de circuits et connecté à ladite antenne et auxdits circuits RF afin de commuter entre la réception et l'émission de signaux RF sur l'antenne ;
un blindage métallique RF (212) entourant ledit amplificateur de puissance et ledit commutateur d'antenne afin d'isoler ledit amplificateur de puissance et ledit commutateur d'antenne de ladite antenne et desdits circuits RF ; et
dans lequel le dispositif mobile de communication sans fil comprend un filtre passe-bas RLC (280) implanté sur la ligne de transmission, le filtre passe-bas RLC ayant une entrée connectée audit amplificateur de puissance et une sortie connectée audit commutateur d'antenne et le filtre passe-bas RLC étant destiné à réduire l'éventuel couplage RF d'ondes stationnaires de fréquences harmoniques supérieures entre l'amplificateur de puissance et le commutateur d'antenne, via le blindage RF, tout en conservant la transmission des signaux sur la ligne de transmission à la fréquence fondamentale souhaitée.

2. Dispositif mobile de communication sans fil selon la revendication 1, dans lequel ledit filtre RLC comprend un condensateur (282) et une première résistance (284) connectés en série et une inductance (288) et une seconde résistance (290) connectées en parallèle.

3. Dispositif mobile de communication sans fil selon la revendication 2, dans lequel ledit filtre passe-bas RLC comprend une résistance mise à la masse, connectée en série avec un premier condensateur, et un second condensateur mis à la masse (286), connecté en parallèle avec le premier condensateur.

4. Dispositif mobile de communication sans fil selon la revendication 1, dans lequel ledit blindage RF comprend un boîtier métallique fixé sur ladite au moins une carte de circuits et entourant ledit amplificateur de puissance et ledit commutateur d'antenne.

5. Dispositif mobile de communication sans fil selon la revendication 5 et comprenant en outre un compartiment d'isolation dans lequel sont placés ledit amplificateur de puissance et ledit commutateur d'antenne.

6. Dispositif mobile de communication sans fil selon la revendication 1, dans lequel ledit filtre passe-bas RLC a une entrée connectée audit amplificateur de puissance et une sortie connectée audit commutateur d'antenne, ledit filtre passe-bas RLC comprenant en outre un condensateur (282) et une première résistance connectés en série et une inductance (288) et une seconde résistance (290) connectées en parallèle et ayant des valeurs de résistance, d'inductance et de capacité telles que, à une fréquence fondamentale, l'impédance du condensateur est supérieure à celle de la première résistance et l'impédance de l'inductance est inférieure à celle de la seconde résistance et, aux fréquences harmoniques supérieures, l'impédance du condensateur est réduite et la première résistance devient un élément dominant pour la réduction du couplage RF éventuel d'ondes stationnaires de fréquences harmoniques supérieure entre l'amplificateur de puissance et le commutateur d'antenne via le blindage métallique RF, tout en conservant la transmission des signaux sur la ligne de transmission à la fréquence fondamentale souhaitée.

7. Dispositif mobile de communication sans fil selon la revendication 6, dans lequel ledit filtre passe-bas RLC comprend une résistance mise à la masse, connectée en série avec un premier condensateur, et un second condensateur mis à la masse (286), connecté en parallèle avec le premier condensateur.

8. Dispositif mobile de communication sans fil selon la revendication 6, dans lequel ledit blindage RF comprend un boîtier métallique fixé sur ladite au moins une carte de circuits et entourant ledit amplificateur de puissance et ledit commutateur d'antenne.

9. Dispositif mobile de communication sans fil selon la revendication 6, et comprenant en outre un compartiment d'isolation dans lequel sont placés ledit amplificateur de puissance et ledit commutateur d'antenne.

10. Procédé de fonctionnement d'un dispositif mobile de communication sans fil (20), comprenant les étapes consistant à :
fournir un boîtier (21), une antenne (45) supportée par le boîtier, une carte de circuits (45) portée par le boîtier et possédant des circuits de radiofréquences (RF) coopérant avec l'antenne pour recevoir et émettre des signaux RF via l'antenne, les circuits comprenant une ligne de transmission (266) et un amplificateur de puissance (226) destiné à amplifier des signaux RF devant être transmis sur la ligne de transmission vers l'antenne ;
commuter entre la réception et l'émission de signaux RF sur l'antenne à l'aide d'un commutateur d'antenne (238) ;
isoler l'amplificateur de puissance et le commutateur d'antenne de l'antenne et des circuits RF en entourant l'amplificateur de puissance et le commutateur d'antenne par un blindage métallique RF (212) ; et
réduire l'éventuel couplage RF d'ondes stationnaires de fréquences harmoniques supérieures entre l'amplificateur de puissance et le commutateur d'antenne, via le blindage RF, à l'aide d'un filtre passe-bas RLC (280) implanté sur la ligne de transmission, tout en conservant la transmission des signaux sur la ligne de transmission à la fréquence fondamentale souhaitée.

11. Procédé selon la revendication 10, comprenant en outre l'étape consistant à former un condensateur (282) et une première résistance (284) connectés en série et une inductance (288) et une seconde résistance (290) connectées en parallèle.

12. Procédé selon la revendication 10, comprenant en outre l'étape consistant à former une résistance mise à la masse, connectée en série avec un premier condensateur, et un second condensateur mis à la masse (286), connecté en parallèle avec le premier condensateur.
